# EUROPEAN PATENT APPLICATION

(11) **EP 1 763 071 A1**
(43) Date of publication of application: **14.03.2007**
(21) Application number: 05734547.2
(22) Date of filing: 25.04.2005
(51) Int. Cl.: H01L 21/304

(54) **GaAs SUBSTRATE CLEANING METHOD, GaAs SUBSTRATE MANUFACTURING METHOD, EPITAXIAL SUBSTRATE MANUFACTURING METHOD AND GaAs WAFER**

(30) Priority: 28.06.2004 JP 2004190272
(71) Applicant: Sumitomo Electric Industries, Ltd., Osaka-shi, Osaka 541-0041 (JP)
(72) Inventor: HORIE, Yusuke Itami Works,Sumitomo E.Ind.Ltd., Hyogo 6640016 (JP); NISHIURA, Takayuki Itami Works,Sumitomo E.Ind.Ltd., Hyogo 6640016 (JP); UEMURA, Tomoki Itami Works of Sumitomo E.Ind.Ltd., Hyogo 6640016 (JP)
(74) Representative: Grünecker, Kinkeldey, Stockmair & Schwanhäusser Anwaltssozietät
(86) International application number: PCT/JP2005/007817
(87) International publication number: WO 2006/001117

(57) **Abstract**

The present invention provides a method of cleaning a GaAs substrate with less precipitate particles after cleaning. This cleaning method comprises an acid cleaning step (S11), a deionized water rinsing step (S 12), and a rotary drying step (S 13). First, a GaAs substrate with a mirror finished surface is immersed in an acid cleaning solution in the acid cleaning step (S11). In the acid cleaning step, the cleaning time is less than 30 seconds. Next, the deionized water rinsing step performs the cleaned GaAs substrate with deionized water (S12) to wash away the cleaning solution deposited thereon. Subsequently, the rotary drying step dries the GaAs substrate deposited on deionized water (S 13). This provides the cleaned GaAs substrate with less precipitate particles.

## Description

### Technical Field

The present invention relates to a method of cleaning a GaAs substrate, a method of producing a GaAs wafer, a method of fabricating an epitaxial substrate, and a GaAs wafer.

### Background Art

Patent Document 1 discloses a cleaning method. This cleaning method comprises the steps of: immersing a GaAs substrate in hydrofluoric acid for ten minutes to remove contaminations along with a native oxide film from the surface of the substrate; rinsing the substrate in deionized water. The cleaning step in this production of GaAs substrates is provided to remove organic substances, metals, etc. on the surface of the GaAs substrate using an acid cleaning solution, such as hydrochloric acid or hydrofluoric acid.

Patent Document 2 discloses a method of cleaning a substrate of GaAs semiconductor crystal. The cleaning step in this method is provided to etch an oxide film from the surface of the substrate using an acid solution after organic substances and metals on the surface of the substrate have been removed. After this process, the etched substrate is cleaned with an aqueous alkaline solution and then the substrate is cleaned with ultra-deionized water. Thereafter, the substrate is dried. This method can remove foreign matters such as deposits.
Patent Document 1: Japanese Patent Application Laid-Open No. 10-79363 .
Patent Document 2: Japanese Patent Application Laid-Open No. 2000-340535

### Disclosure of the Invention

If such acid cleaning is used, precipitate particles are produced on the surface of the GaAs substrate with time after the cleaning. This poses the following problem: if an epitaxial film is formed on the GaAs substrate with the precipitate particles remaining on the surface thereof, the precipitate particles increase defects in the epitaxial film. These defects degrade the quality of the epitaxial film.

Under this background, the present invention has been accomplished in order to provide a method of cleaning a GaAs substrate to form the cleaned GaAs substrate with less precipitate particles thereon.

It is an object of the present invention to provide a method of fabricating a GaAs substrate with less precipitate particles after cleaning, to provide a method of producing an epitaxial substrate by using the GaAs substrate, to provide a method of cleaning a GaAs substrate to form the cleaned GaAs substrate with less precipitate particles after cleaning, and to provide a GaAs substrate.

The present invention is a method of cleaning a GaAs substrate, which comprises: an acid cleaning step of subjecting a GaAs substrate to cleaning using an acid solution for less than 30 seconds. According to this method, a cleaning time for the acid cleaning step is less than 30 seconds, the number of precipitate particles on the cleaned GaAs substrate is reduced.

Another aspect of the present invention is a method of cleaning a GaAs substrate, which comprises: an acid cleaning step of subjecting a GaAs substrate to a plurality of acid cleanings, an acid solution for one acid cleaning of the plurality of acid cleanings being different from that for another cleaning thereof, and a total period of time for the plurality of acid cleanings being less than 30 seconds.

According to this method, these acid cleaning steps use their respective acid solutions different from each other. The acid cleanings can be performed according to characteristics of the respective acid solutions. Furthermore, since the total period of time for the plurality of acid cleaning steps is less than 30 seconds, the number of precipitate particles on the cleaned GaAs substrate is reduced.

Another aspect of the present invention is a method of cleaning a GaAs substrate, (a) an alkali cleaning step of subjecting a GaAs substrate to cleaning using an alkaline solution; and (b) an acid cleaning step of subjecting the GaAs substrate to cleaning using an acid solution after the alkali cleaning step. Ultrasonic wave is applied to the GaAs substrate during the cleaning in the alkali cleaning step, and a cleaning time in the acid cleaning step is less than 30 seconds.

According to this method, the application of ultrasonic wave to the GaAs substrate in the alkali cleaning can remove particles on the GaAs substrate more effectively. Furthermore, since a cleaning time in the acid cleaning step is less than 30 seconds, it improves roughening of the surface of the substrate caused by the alkali cleaning, and the number of precipitate particles on the cleaned GaAs substrate is small.

Another aspect of the present invention is a method of cleaning a GaAs substrate, which comprises: (a) a first acid cleaning step of subjecting a GaAs substrate to cleaning using an acid solution; (b) an alkali cleaning step of subjecting the GaAs substrate to cleaning using an alkaline solution after the first acid cleaning step; and (c) a second acid cleaning step of subjecting the GaAs substrate to cleaning using an acid solution after the alkali cleaning step. A cleaning time in the second acid cleaning step is less than 30 seconds.

According to this method, the first acid cleaning step can remove metal impurities, organic substances, a native oxide film, etc. on the GaAs substrate. The alkali cleaning step is carried out after the first acid cleaning step, and thus suppress precipitation of precipitate particles due to the first acid cleaning. Since the acid cleaning for less than 30 seconds is carried out after the alkali cleaning, this method improves roughening of the surface of the substrate caused by the alkali cleaning, and the number of precipitate particles on the cleaned GaAs substrate is small.

Preferably, ultrasonic wave is applied to the GaAs substrate during the cleaning in the alkali cleaning step. In this method, he alkali cleaning with application of the ultrasonic wave can remove particles acquired on the substrate more effectively.

The acid solution used as the cleaning solution in the acid cleaning step can be one containing at least one of nitric acid, hydrofluoric acid, hydrochloric acid, phosphoric acid, sulfuric acid, acetic acid, carbonic acid, lactic acid, formic acid, citric acid, malic acid, and phthalic acid.

The alkaline solution used as the cleaning solution in the alkali cleaning step can contain at least one of ammonia, ethylhydroxyl, 2-ethoxyethylamine, triethanolamine, diethanolamine, ethylamine, trimethylamine, diethylamine, dimethylamine, ethanolamine, trimethylammonium hydroxide, tetraethylammonium hydroxide, and tetramethylammonium hydroxide.

Still another aspect of the present invention is a method of cleaning a GaAs substrate for production of a GaAs wafer. This method comprises a step of treating the GaAs substrate with an acid solution for a time of less than 30 seconds. Since this method comprises the acid treating step for the treatment time of less than 30 seconds, the number of precipitates on the GaAs substrate after the treatment is small.

Still another aspect of the present invention is a method of cleaning a GaAs substrate for production of a GaAs wafer. This method comprises the step of: subjecting a surface of the GaAs substrate to a plurality of treatments using a plurality of acid solutions, one acid solution of the plurality of acid solutions being different from that of another treatment, and a total period of time for treating the GaAs substrate with the acid solutions being less than 30 seconds. This method permits the acid treatments according to characteristics of the respective acid solutions. Since the total period of time for the plurality of acid treatments is less than 30 seconds, the number of precipitate particles on the GaAs substrate after the treatments is small.

Still another aspect of the present invention is a method of cleaning a GaAs substrate for production of a GaAs wafer. This method comprises the steps of: treating the GaAs substrate with an alkaline solution; and treating the GaAs substrate with an acid solution for less than 30 seconds, after treating the GaAs substrate with the alkaline solution. The step of treating the GaAs substrate with the alkaline solution comprises a step of immersing the GaAs substrate in the alkaline solution while applying ultrasonic wave. In this method, the application of ultrasonic wave to the GaAs substrate in the treatment with the alkaline solution can remove particles acquired on the GaAs substrate more effectively. Furthermore, since the acid treatment is carried out for less than 30 seconds, this method improves roughening of the surface of the substrate caused by the alkali cleaning, and the number of precipitates on the cleaned GaAs substrate is small.

Still another aspect of the present invention is a method of cleaning a GaAs substrate for production of a GaAs wafer. This method comprises the steps of: treating the GaAs substrate with an acid solution; treating the GaAs substrate with an alkaline solution after treating the GaAs substrate with the acid solution; and treating the GaAs substrate with an acid solution for less than 30 seconds after treating the GaAs substrate with the alkaline solution. In this method, metal impurities, organic substances, a native oxide film, etc. on the GaAs substrate can be removed by the treatment with the first acid solution. The treatment with the alkaline solution reduces the number of precipitates generated by the previous acid treatment. The treatment with the second acid solution improves roughening of the surface of the substrate caused by the alkali cleaning, and the number of precipitate particles on the cleaned GaAs substrate is small. Preferably, the step of treating the GaAs substrate with the alkaline solution comprises a step of immersing the GaAs substrate in the alkaline solution while applying ultrasonic wave to the alkaline solution. Particles on the substrate can be removed more effectively by the alkali cleaning with application of ultrasonic wave.

Still another aspect of the present invention is a method of cleaning a GaAs substrate for production of a GaAs wafer. This method comprises the step of treating a GaAs substrate with an acid solution, the acid solution having a hydrogen ion concentration (pH) of not more than 6.4. It is feasible to provide the GaAs substrate permitting stable production of an epitaxial film with less haze, in epitaxial growth using the treated GaAs substrate.

Still another aspect of the present invention is a method of cleaning a GaAs substrate for production of a GaAs wafer. This method comprises the step of treating a GaAs substrate with an acid solution, the acid solution being a mixed solution of hydrofluoric acid and hydrogen peroxide solution, and a concentration of the hydrofluoric acid in the mixed solution being not more than 5.0 wt%. This method provides the GaAs substrate permitting stable growth of an epitaxial film with less haze, and the number of precipitate particles on the surface becomes smaller.

In still another aspect of the present invention, the method comprises the step of, prior to treating the GaAs substrate with the acid solution, treating the GaAs substrate with an alkaline solution. This method permits the alkaline solution having a great ability for removing microparticles in combination with the acid solution, and thus further improves cleanliness of the surface of the GaAs substrate.

The alkaline solution used as the cleaning solution in the alkali cleaning step can be one selected from the following examples. The alkaline solution can contain at least one of ammonia, ethylhydroxyl, 2-ethoxyethylamine, triethanolamine, diethanolamine, ethylamine, trimethylamine, diethylamine, dimethylamine, ethanolamine, trimethylammonium hydroxide, tetraethylammonium hydroxide, and tetramethylammonium hydroxide.

The acid solution used as the cleaning solution in the acid cleaning step can be one selected from the following examples. The following acid solutions can be applied. The acid solution can contain at least one of nitric acid, hydrofluoric acid, hydrochloric acid, phosphoric acid, sulfuric acid, acetic acid, carbonic acid, lactic acid, formic acid, citric acid, malic acid, and phthalic acid.

Another aspect of the present invention is a method of producing a GaAs wafer, which comprises the steps of: polishing a surface of a GaAs slice prepared by slicing a GaAs single crystal ingot, to form a GaAs substrate; and subjecting the polished GaAs substrate to the cleaning or treatment according to the present invention. This method provides the production of the GaAs substrate with the reduced number of precipitate particles thereon.

Another aspect of the present invention is a method of producing an epitaxial substrate, which comprises the steps of: polishing a surface of a GaAs slice prepared by slicing a GaAs single crystal ingot to form a GaAs substrate; and treating the GaAs substrate by the method or treatment according to the present invention, to produce the GaAs wafer. This method provides the production of an epitaxial substrate with less defects in the epitaxial film thereon.

Another aspect of the present invention is a GaAs substrate having a cleaned primary surface. The primary surface has a characteristic that a ratio of an area of a Ga (3d) peak intensity to an area of an As (3d) peak intensity in XPS evaluation is not less than 0.59. In the GaAs substrate according to the present invention, precipitate particles of not less than 0.4 µm on the primary surface are not more than 15 particles/12.57 inch². By using the GaAs substrate, it is feasible to stably obtain an epitaxial film with less defects.

Another aspect of the present invention is a GaAs wafer including a cleaned principal surface. The primary surface has a surface roughness of not more than 0.21 nm. Another aspect of the present invention is a GaAs wafer including a cleaned primary surface. The primary surface has a characteristic that a ratio of an area of a Ga (3d) peak intensity to an area of an As (3d) peak intensity in an XPS spectrum is not more than 1.5. It is feasible to provide the GaAs wafer permitting stable production of an epitaxial film with less haze, in epitaxial growth using the wafer. In the above GaAs wafer, precipitate particles on the primary surface are not more than 1.2 particles/cm². By using this GaAs wafer, it is feasible to stably form the epitaxial film with less haze and less defects.

### Industrial Applicability

The method of cleaning a GaAs substrate, the method of fabricating a GaAs wafer, and the method of fabricating an epitaxial substrate according to the present invention can reduce the number of precipitate particles after the cleaning.

In addition, the present invention provides the following: the method of fabricating an epitaxial substrate with the use of the GaAs wafer on which the small number of precipitate particles after the cleaning remain; the method of cleaning a GaAs substrate to reduce the number of precipitate particles after the cleaning; and the GaAs wafer with the small number of precipitate particles being thereon after the cleaning.

### Brief Description of the Drawings

The above objects and other objects, features, and advantages of the present invention will become more readily apparent in view of the following detailed description of preferred embodiments of the present invention with reference to the accompanying drawings:
Fig. 1 is a flowchart showing a method of cleaning a GaAs substrate according to the first embodiment of the present invention.
Fig. 2 is a flowchart showing a method of cleaning a GaAs substrate according to the second embodiment of the present invention.
Fig. 3 is a flowchart showing a method of cleaning a GaAs substrate according to the third embodiment of the present invention.
Fig. 4 is a flowchart showing a method of cleaning a GaAs substrate according to the fourth embodiment of the present invention.
Fig. 5 is a flowchart showing a method of cleaning a GaAs substrate according to the fifth embodiment of the present invention.
Fig. 6 includes area (a) showing a flowchart for a method of fabricating a GaAs wafer according to the sixth embodiment of the present invention, and area (b) showing an illustration for a GaAs wafer obtained by the method of fabricating a GaAs wafer according to the sixth embodiment.
Fig. 7 includes area (a) showing a flowchart for the method of fabricating an epitaxial substrate according to the seventh embodiment of the present invention; and area (b) showing an illustration for an epitaxial substrate obtained by the method of fabricating a GaAs wafer according to the seventh embodiment.
Fig. 8 is a diagram showing the relationship between the number of precipitate particles observed on a GaAs substrate and the number of defects observed in an epitaxial film.
Fig. 9 is a diagram showing the relationship between the number of precipitate particles and the intensity ratio of the area-of the Ga 3d peak and the area of the As 3d peak in X-ray photoelectron spectroscopy measurement.
Fig. 10 is a diagram showing the relationship between the period of time for acid cleaning and the number of precipitate particles.
Fig. 11 is a diagram showing the relationship between haze of a surface of epitaxial layers and surface roughness of GaAs substrates.
Fig. 12 is a diagram showing results of X-ray photoelectron spectroscopy (XPS) measurement.
Fig. 13 is a diagram showing the relationship between surface roughnesses of substrates treated with a number of solutions and hydrogen ion concentrations (pH) of the solutions.
Fig. 14 is a diagram showing the relationship between density of precipitate particles and concentrations of hydrofluoric acid solutions.

### Best Modes for Carrying out the Invention

Embodiments of the present invention will be described below with reference to the accompanying drawings.

### (First Embodiment)

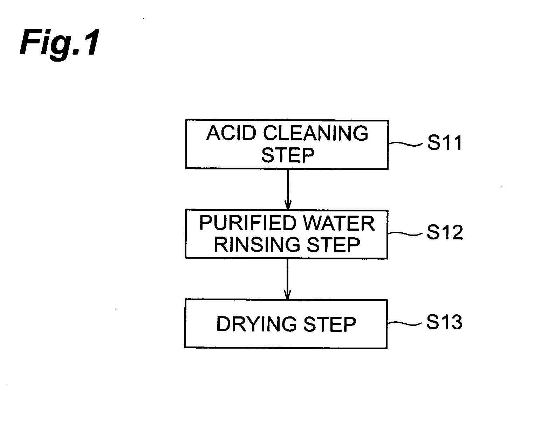

Fig. 1 is a flowchart showing a method of cleaning a GaAs substrate according to the first embodiment of the present invention. As shown in Fig. 1, the cleaning method according to the present embodiment has the primary steps of an acid cleaning step (S11), a deionized water rinsing step (S 12), and a spin drying step (S 13). In the cleaning method of the present embodiment, the first step S11 of the acid cleaning step performs the immersing of a GaAs substrate having a mirror finished surface into an acid cleaning solution. In this acid cleaning step, for example, a number of GaAs substrates are set in a wafer carrier, and the GaAs substrates held by the wafer carrier are immersed into the cleaning solution in a cleaning bath to effect the cleaning. The cleaning solution for the acid cleaning step can contain, for example, one of nitric acid, hydrofluoric acid, hydrochloric acid, phosphoric acid, sulfuric acid, acetic acid, carbonic acid, lactic acid, formic acid, citric acid, malic acid, and phthalic acid. Alternatively, the cleaning solution can be a mixed solution of two or more of the above acids. In this acid cleaning step, a period of time for cleaning the GaAs substrate is less than 30 seconds. The cleaning time less than 30 seconds can reduce the generation of precipitate particles. In order to suppress the generation of precipitate particles more effectively, the cleaning time of the acid cleaning step is more preferably not more than 20 seconds. In order to remove metal contaminations and organic substances on the GaAs substrate more effectively, the cleaning time in the acid cleaning step is more preferably not less than 10 seconds.

In the next step S12, the deionized water rinsing step is performed, so that deionized water washes away the cleaning solution deposited on the cleaned GaAs substrate. As in the above acid cleaning step, the GaAs substrates are set in the wafer carrier in this deionized water rinsing step and are immersed into deionized water in a cleaning bath to wash away the cleaning solution attached to the GaAs substrates. In this deionized water rinsing step, deionized water may be circulated in the cleaning bath.

In the step S13, the drying step performs the drying of the GaAs substrates. In the drying step, the GaAs substrates are rotated to blow off water by centrifugal force, thereby drying the GaAs. The drying step provides the dried GaAs substrates. The drying method can be rotary drying, and alternatively can be, for example, vacuum drying, hot air drying, IPA (isopropyl alcohol) vapor drying, Marangoni drying, or Rotagoni drying.

As described above, in the cleaning method according to the present embodiment, the acid cleaning step performs the cleaning for less than 30 seconds with the acid solution. Accordingly, the number of precipitate particles on the cleaned GaAs substrate is reduced.

### (Second Embodiment)

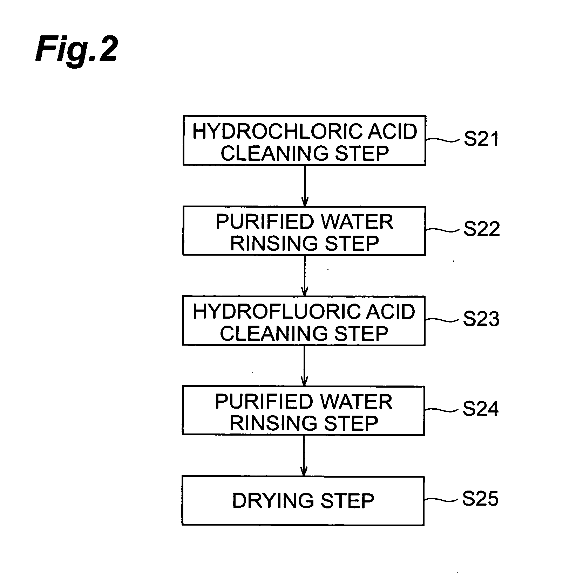

Fig. 2 is a flowchart showing a method of cleaning a GaAs substrate according to the second embodiment of the present invention. The present embodiment is different from the above first embodiment in the following point: the method according to the present embodiment includes a plurality of acid cleaning steps, and an acid solution in one acid cleaning step thereof is different from that in another acid cleaning step thereof. In the cleaning method according to the present embodiment, the first step is a hydrochloric acid cleaning step S21 of cleaning a GaAs substrate with a cleaning solution of hydrochloric acid. After the hydrochloric acid cleaning step, a deionized water rinsing step S22 washes away hydrochloric acid from the GaAs substrate. A hydrofluoric acid cleaning step S23 cleans the GaAs substrate with a cleaning solution of hydrofluoric acid. After the hydrofluoric acid cleaning step, a deionized water rinsing step S24 washes away hydrofluoric acid from the GaAs substrate. A rotary drying step S25 dry the GaAs substrate. The total period of time for cleaning in the hydrochloric acid cleaning step and the hydrofluoric acid cleaning step is less than 30 seconds. More preferably, the total period of time for cleaning in these acid cleaning steps is set in the range of 10 seconds to 20 seconds. If the total period of time for cleaning is not less than 10 seconds, metal contaminations and organic substances remaining on the GaAs substrate can be removed more effectively. When the total period of the time for cleaning is not more than 20 seconds, the occurrence of precipitate particles can be suppressed more effectively. Accordingly, the number of precipitate particles on the cleaned GaAs substrate can be reduced even after the plurality of acid cleaning steps have been carried out.

In the cleaning of the GaAs substrate, the quality of the surface of the substrate depends on cleaning methods. Requirements for the quality of the surface of the cleaned substrate vary depending upon the epitaxial layers that will be formed later. The quality of the surface of the cleaned substrate can be changed by use of a different composition of the cleaning solution, but there are cases where a single acid cleaning by use of a single kind of cleaning solution cannot produce a desired quality of the surface of the GaAs substrates. Even in such cases, the present embodiment can provide the substrate with a desired quality of its surface after the cleaning by carrying out a plurality of acid cleaning steps, each of which uses an acid solution different from that for another acid cleaning step. The example in Fig. 2 uses the two acid cleaning steps, e.g., the hydrochloric acid cleaning step and the hydrofluoric acid cleaning step, but the present embodiment is not limited to this example and can also be arranged to carry out three or more acid cleaning steps. In addition, the acid solutions used as the cleaning solutions in the respective acid cleaning steps can be selected from the variety of etchants described in the first embodiment.

### (Third Embodiment)

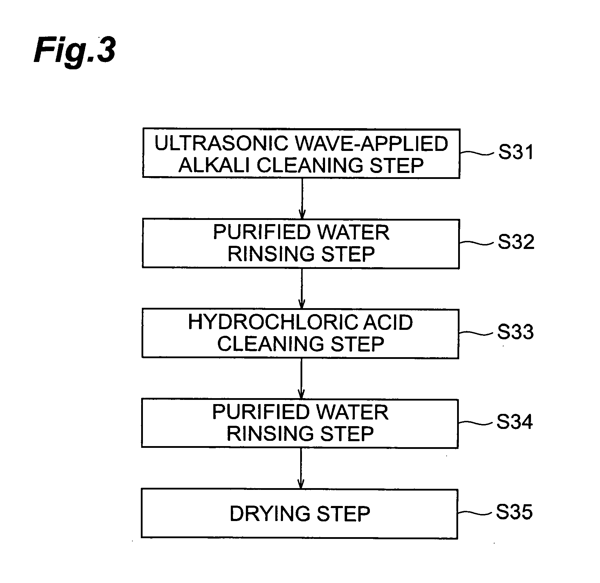

In a cleaning method of the present embodiment, as shown in Fig. 3, the first step S31 is an alkali cleaning step of performing the cleaning of a GaAs substrate with an alkaline solution while applying ultrasonic wave to the GaAs substrate (S31). This alkali cleaning step is carried out as flows: setting GaAs substrates in a wafer carrier as described in the foregoing acid cleaning step and deionized water rinsing step; and immersing them into an alkaline solution in a cleaning bath. The alkaline solution contains at least one of ammonia, ethylhydroxyl, 2-ethoxyethylamine, triethanolamine, diethanolamine, ethylamine, trimethylamine, diethylamine, dimethylamine, ethanolamine, trimethylammonium hydroxide, tetraethylammonium hydroxide, and tetramethylammonium hydroxide. Alternatively, the alkaline solution can be a mixed solution of two or more of these.

After the alkali cleaning step, a deionized water rinsing step S32 carries out the washing away of the alkaline solution on the GaAs substrate. Subsequently, a hydrochloric acid cleaning step S33 performs hydrochloric acid cleaning for a cleaning time of less than 30 seconds as in the first embodiment, and then a deionized water rinsing step S34 and a drying step S35 are carried out. In the cleaning method according to the present embodiment, if an ultrasonic wave-applied alkali cleaning step is first carried out, the particles on the GaAs substrate can be effectively removed. Furthermore, the acid cleaning step is carried out for a cleaning time of less than 30 seconds, which can reduce the surface roughness of the GaAs substrate that has been caused in the ultrasonic wave-applied alkali cleaning step and which can reduce the number of precipitate particles on the cleaned GaAs substrate. The application of ultrasonic wave to the GaAs substrate can be implemented, for example, by generating the ultrasonic wave of 20-40 kHz by means of an ultrasonic transducer installed in the cleaning bath.

### (Fourth Embodiment)

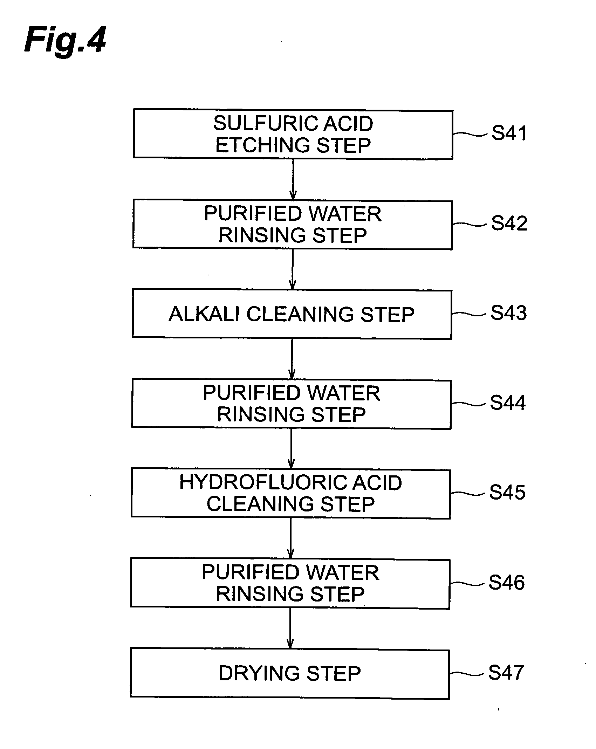

Fig. 4 is a flowchart showing a method of cleaning a GaAs substrate according to the fourth embodiment of the present invention. In the present embodiment, a first acid cleaning step is carried out with an acid solution, an alkali cleaning step is carried out after the first acid cleaning step, a second acid cleaning step is carried out after the alkali cleaning step, and a cleaning time for this second acid cleaning step is less than 30 seconds. In the present embodiment, the first sulfuric acid etching step S41 uses sulfuric acid as an etching solution for the first acid cleaning. There are no particular restrictions on a cleaning time in this sulfuric acid etching step, and thus the cleaning time may be 30 seconds or more. This permits acid cleaning for a longer time to remove a native oxide film and metal contaminations and organic substances, for example, in the following cases: the native oxide film formed on the surface of the GaAs substrate is desired to be completely removed; and a cleaning time for 30 seconds or less cannot sufficiently remove the metal contaminations and organic substances. This sulfuric acid etching step can be carried out in the same manner as in the acid cleaning step according to the first embodiment, except that the cleaning time is not limited to less than 30 seconds.

After a deionized water rinsing step S42 washes away sulfuric acid from the GaAs substrate, an alkali cleaning step S43 performs alkali cleaning of the GaAs substrate. This alkali cleaning step can be carried out in the same manner as in the ultrasonic wave-applied alkali cleaning step according to the third embodiment, except that no ultrasonic wave is applied to the GaAs substrate. Even if acid cleaning prior to this alkali cleaning step is carried out for a period of cleaning time of not less than 30 seconds, the alkali cleaning step can suppress precipitation of precipitate particles resulting from that acid cleaning step.

A deionized water rinsing step S44 washes away the alkaline solution from the GaAs substrate. Thereafter, a hydrofluoric acid cleaning step S45 for the second acid cleaning performs hydrofluoric acid cleaning of the GaAs substrate. This hydrofluoric acid cleaning step performs acid cleaning for less than 30 seconds, as in the acid cleaning step according to the first embodiment. The second acid cleaning can improve roughening of the surface of the GaAs substrate caused in the alkali cleaning step and can reduce the number of precipitate particles on the cleaned GaAs substrate.

A next deionized water rinsing step S46 washes away hydrofluoric acid from the GaAs substrate and then a drying step S47 dries the GaAs substrate.

Since the cleaning method according to the present embodiment is provided to perform the alkali cleaning step between the first acid cleaning step and the second acid cleaning step, it can suppress precipitation of precipitate particles due to the first acid cleaning step. Thereafter, acid cleaning for a cleaning time of less than 30 seconds is performed in the second acid cleaning step, whereby roughening of the surface of the GaAs substrate due to the alkali cleaning step can be improved and the number of precipitate particles after the cleaning can be reduced.

### (Fifth Embodiment)

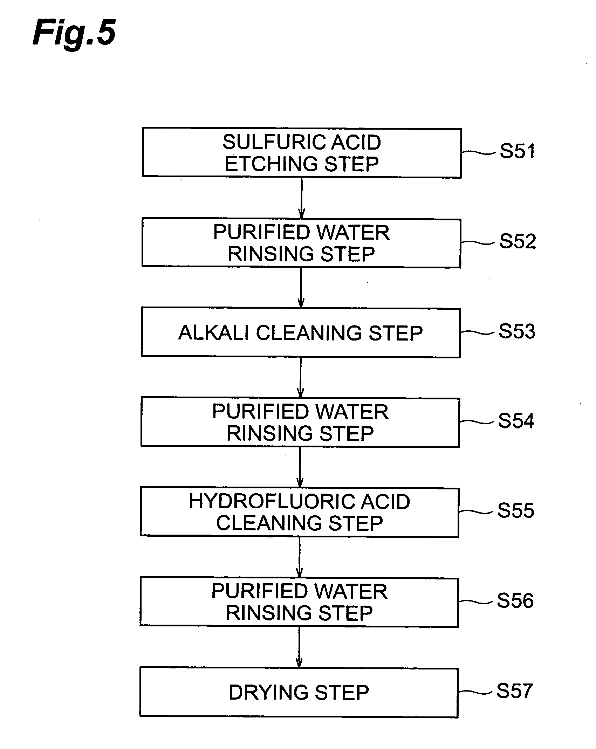

Fig. 5 is a flowchart showing a method of cleaning a GaAs substrate according to the fifth embodiment according to the present invention. The present embodiment is different from the cleaning method of the fourth embodiment in that an alkali cleaning step performs alkali cleaning with application of ultrasonic wave to the GaAs substrate. In the present embodiment, a sulfuric acid etching step S51 and a deionized water rinsing step S52 are carried out in the same manner as the step S41 and the step S42 in the fourth embodiment, respectively. Thereafter, an alkali cleaning step S53 performs the alkali cleaning of the GaAs substrate while applying ultrasonic wave to the GaAs substrate. This alkali cleaning step can be performed in the same manner as the alkali cleaning step in the third embodiment. Then, a deionized water rinsing step S54 and a hydrofluoric acid cleaning step S55 for a cleaning time of less than 30 seconds are carried out in the same manner as the step S44 and the step S45 in the fourth embodiment, respectively. Thereafter, a step S56 of a deionized water rinsing step and a step S57 of a drying step are carried out in the same manner as the step S46 and the step S47 in the fourth embodiment, respectively. Since the step S53 performs the alkali cleaning of the GaAs substrate-while applying the ultrasonic wave to the substrate, this can suppress the precipitation of precipitate particles as in the alkali cleaning step in the fourth embodiment, and in addition can effectively remove the particles on the GaAs substrate. Since the cleaning time in the acid cleaning step S55 is less than 30 seconds, roughening of the surface of the GaAs substrate caused in the alkali cleaning step can be improved and the number of precipitate particles after the cleaning can be reduced.

### (Sixth Embodiment)

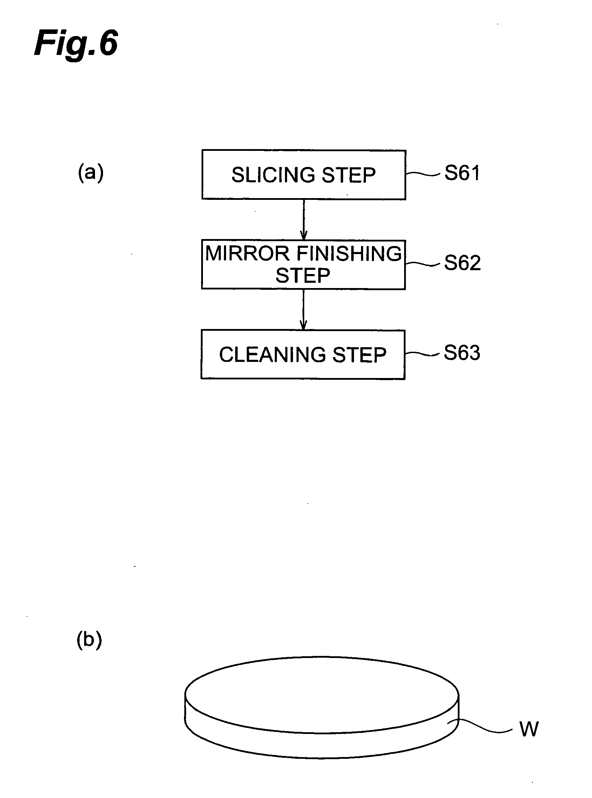

Area (a) of Fig. 6 shows a flowchart for a method of producing a GaAs wafer according to the sixth embodiment of the present invention. In the present embodiment, the cleaning method of the present invention as described above is carried out for production of a GaAs wafer. In the present embodiment, a slice step S61 slices a GaAs single crystal ingot to form one or more GaAs slices. In this slice step S61, the GaAs single crystal ingot is processed into a wafer shape by an inner saw slicer, an outer saw slicer, a wire saw, or the like, to prepare GaAs slices. A mirror finish step S62 polishes a surface of each GaAs slice into a mirror finished surface. This mirror finish step can be performed, for example, by use of a mechano-chemical polishing (CMP) system. A cleaning step S63 performs the cleaning method according to any one of the first to fifth embodiments to complete a GaAs wafer W shown in area (b) in Fig. 6. The cleaning method removes metal contaminations, organic substances, and particles to produce the GaAs wafer with less precipitate particles.

### (Seventh Embodiment)

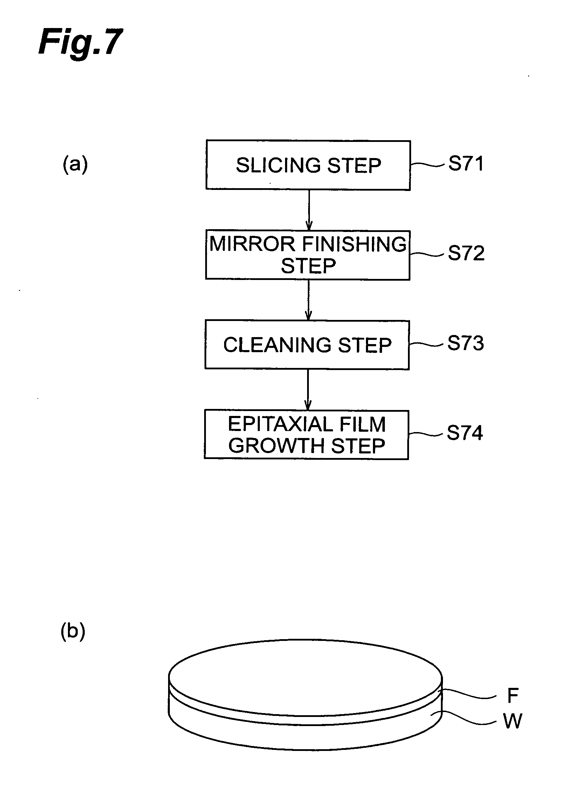

Area (a) in Fig. 7 shows a flowchart for a method of producing an epitaxial substrate according to the seventh embodiment of the present invention. In the present embodiment, a slice step S71, a mirror finish step S72, and a cleaning step S73 are carried out in the same manner as in the sixth embodiment. As shown in area (b) in Fig. 7, an epitaxial film step S74 grows an epitaxial film F on a cleaned GaAs wafer W. This epitaxial film forming step is preferably provided to form the epitaxial film F by the molecular beam epitaxy (MBE) or metal organic vapor phase epitaxy (MOVPE). In the present embodiment, since the GaAs wafer W with less precipitate particles thereon is obtained in the step S73, the epitaxial film F is deposited on the surface of the GaAs wafer W and defects in the epitaxial film F can be reduced.

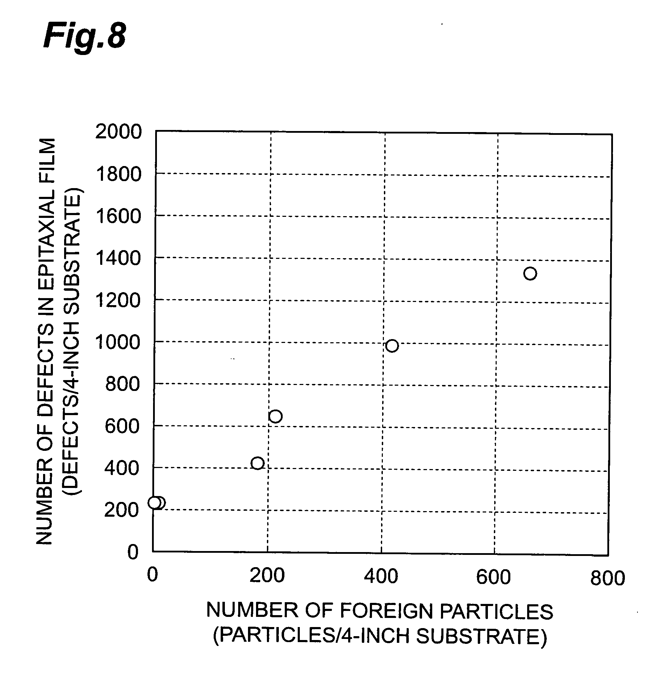

Fig. 8 is a diagram showing the relationship between the number of precipitate particles on the GaAs substrate and the number of defects in the epitaxial film. The horizontal axis in Fig. 8 represents the number of precipitate particles of not less than 0.4 µm appeared on the GaAs substrate before the epitaxial growth, and the vertical axis in Fig. 8 represents the number of defects of not less than 1 µm observed in the epitaxial film. For obtaining these data, semi-insulating GaAs substrates of 4-inch diameter (about 10 cm) are cleaned for varied periods of time with a mixed solution of hydrofluoric acid 0.5 wt%, hydrochloric acid 1.0 wt%, and hydrogen peroxide solution 0.1 wt%, followed by rinsing with deionized water and spin drying. Thereafter, the dried GaAs substrates are left still for one day and then precipitate particles having the size of not less than 0.4 µm are counted with a mirror surface scanner. Furthermore, an undoped GaAs film of the thickness of 1 µm is epitaxially grown thereon by MBE. Then defects of the size of not less than 1.0 µm on the epitaxial film are counted with a mirror surface scanner.

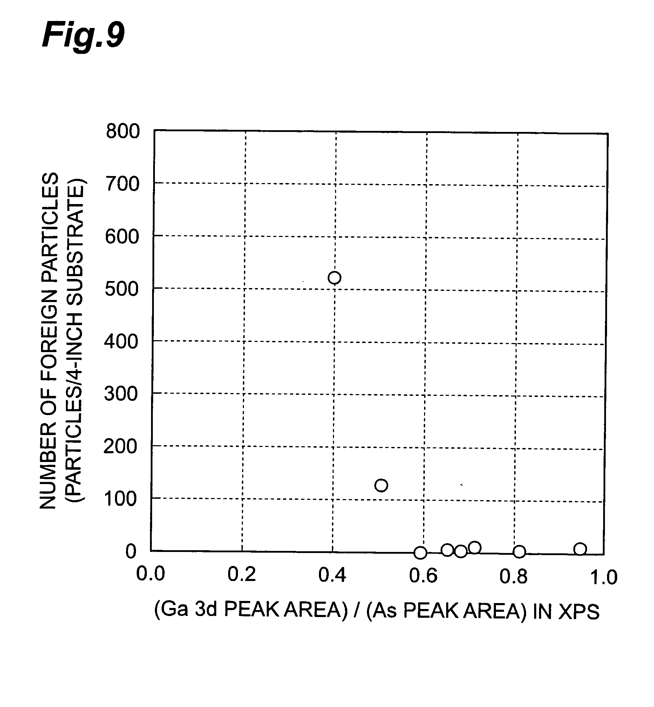

Next, the semi-insulating 4-inch GaAs substrates are subjected to X-ray photoelectron spectroscopy (XPS) measurement. This measurement is carried out as follows: after executing the acid cleaning and the measurement of precipitate particles in the same manner as above, the XPS measurement is conducted using AlKα as an X-ray source and under the condition that the photoelectron takeoff angle is 10 degrees relative to the surface of the substrate, and an area ratio of the Ga 3d peak intensity to the As 3d peak intensity is determined. Fig. 9 is a diagram showing the relationship between the number of precipitate particles and (Ga 3d peak area intensity)/(As 3d peak area intensity) in the XPS measurement. The horizontal axis in Fig. 9 represents the area intensity ratio of the Ga 3d peak to the As 3d peak, and the vertical axis in Fig. 9 represents the number of precipitate particles. It is seen from Fig. 9 that the number of precipitate particles is not more than 15 if this peak ratio, (Ga 3d peak area intensity)/(As 3d peak area intensity), is not less than 0.59. This result shows that the number of precipitate particles can be calculated based on the ratio, (Ga 3d peak area intensity)/(As 3d peak area intensity) in the XPS measurement.

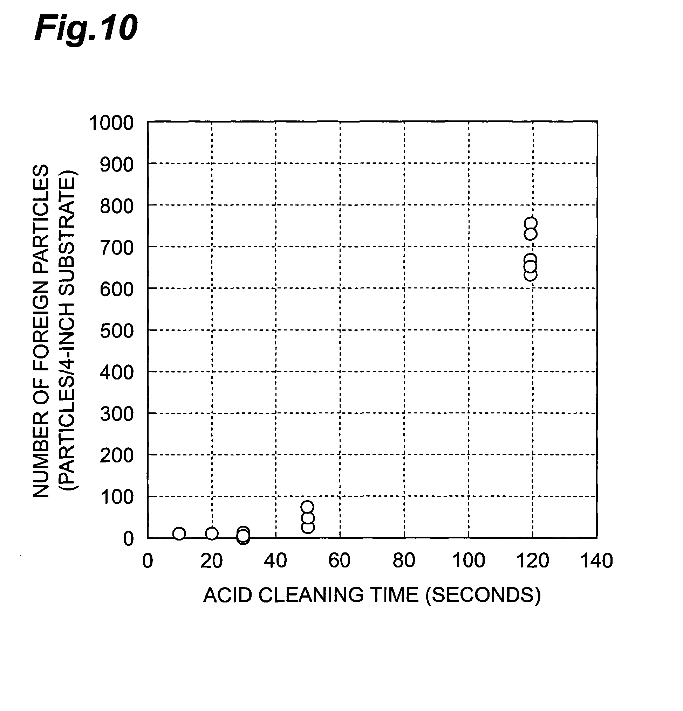

Furthermore, the above acid cleaning is conducted using the semi-insulating 4-inch GaAs substrates with change in the cleaning time between 10 seconds and 120 seconds. The measurement of precipitate particles is conducted with a mirror surface scanner. Fig. 10 is a diagram showing the relationship between the acid cleaning time and the number of precipitate particles. It is seen from Fig. 10 that the number of precipitate particles becomes as small as not more than 15 particles/4-inch substrate if the acid cleaning time is less than 30 seconds. The ratio of Ga 3d peak area intensity/As 3d peak area intensity is determined by XPS measurement of the GaAs substrates for which the acid cleaning time of less than 30 seconds is used. As a result, this area intensity ratio is not less than 0.59 and the number of precipitate particles is not more than 15 particles/4-inch substrate.

The method of cleaning a GaAs substrate and the method of fabricating a GaAs substrate according to the present invention are not limited to the above-described embodiments, but it is a matter of course that they can be modified in various ways without departing from the scope of the present invention.

### (Eighth Embodiment)

For example, a 4-inch semi-insulating GaAs substrate is processed by the cleaning method as described in the above embodiments. The whole GaAs substrate is immersed in a solution, such as an acid solution and an alkaline solution, to perform the treatment of the GaAs substrate. This treatment cleans the surface of the GaAs substrate. After this treatment, the whole GaAs substrate is immersed in deionized water to perform a rinsing treatment of the GaAs substrate. After the rinsing treatment, the GaAs substrate is dried with a centrifugal drier. In an example, the forgoing solution can be one of hydrofluoric acid solution, hydrogen dissolved water, carbonic water, hydrogen peroxide solution, ammonia water, and a mixed solution of two or more of these. - In the treatment with the solution, the GaAs substrate can be treated while applying ultrasonic wave, such as the megasonic wave, to the solution. A semiconductor film is epitaxially grown on the GaAs substrate that has been subj ected to the sequence of these treatments and haze on the surface thereof is measured. By use of the epitaxial growth a GaAs film of not more than 1 µm is formed by molecular beam epitaxy, for example. Then, the measurement of haze is carried out with a mirror surface scanner. In addition, the surface roughness Ra of another GaAs substrate that has been subjected to the sequence of these treatments is measured with an atomic force microscope (AFM) apparatus. In this measurement, a short needle of Si is used as a probe, the view field of 1 µm square is scanned 125 or more times to generate a single image, and thereafter the surface roughness Ra is determined using data resulting from a flattening process of the image.

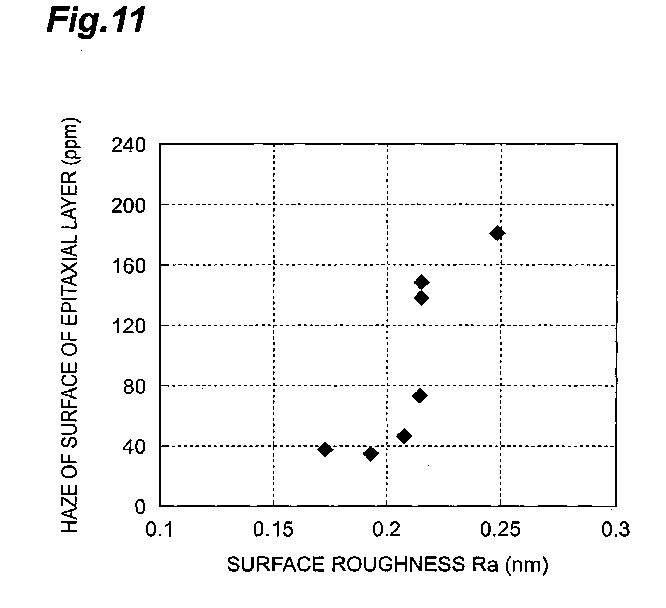

Fig. 11 is a diagram showing the relationship between the haze of the surface of the epitaxial layer and the surface roughness of the GaAs substrate. The rougher the surface of the substrate is, the greater the haze of the surface of the epitaxial layer grown thereon is. Accordingly, the surface roughness of the substrate after completion of the cleaning is preferably not more than 0.21 nm.

### (Ninth Embodiment)

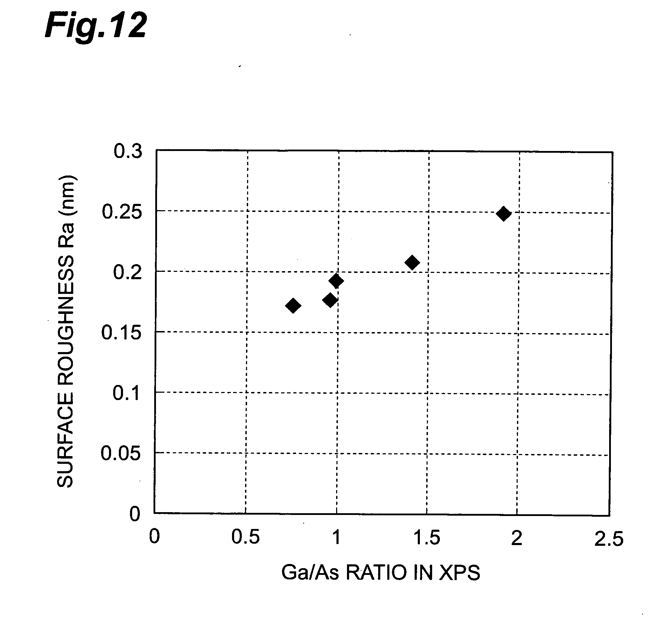

A GaAs substrate is treated by the cleaning method as described in the above embodiments. For example, a 4-inch semi-insulating GaAs substrate is treated with a solution, such as an acid solution and an alkaline solution. After this cleaning, the GaAs substrate is subjected to a rinsing treatment with deionized water. After the rinsing treatment, the GaAs substrate is dried with a centrifugal drier. In one example, one of hydrofluoric solution, hydrogen dissolved water, carbonic water, hydrogen peroxide solution, ammonia water, and a mixed solution of two or more of these can be used as the above solution. In the treatment with this solution, the GaAs substrate can be treated while applying megasonic wave to the solution. The surface roughness Ra of the GaAs substrate that has been subjected to the sequence of these treatments is measured with an atomic force microscope (AFM) apparatus. This measurement can be carried out in the same manner as in the method described in the eighth embodiment. After this measurement of surface roughness Ra, the X-ray photoelectron spectroscopy (XPS) measurement is conducted to determine the area ratio of the Ga 3d peak intensity to the As 3d peak intensity. Fig. 12 is a drawing showing the measurement result of X-ray photoelectron spectroscopy (XPS). In this measurement, for example, the X-ray photoelectron spectroscopy is conducted at the photoelectron takeoff angle of 10 degrees relative to the surface of the substrate and using AlKα as an X-ray source. This intensity ratio is defined by (Ga 3d peak area intensity)/(As 3d peak area intensity) (hereinafter referred to as "Ga/As"). The lower Ga/As is, the flatter the surface is. When the surface roughness is not more than 0.21 nm, Ga/As is not more than 1.5. According to this result, Ga/As is preferably not more than 1.5 on the surface of the substrate after completion of the cleaning of the GaAs substrate.

### (Tenth Embodiment)

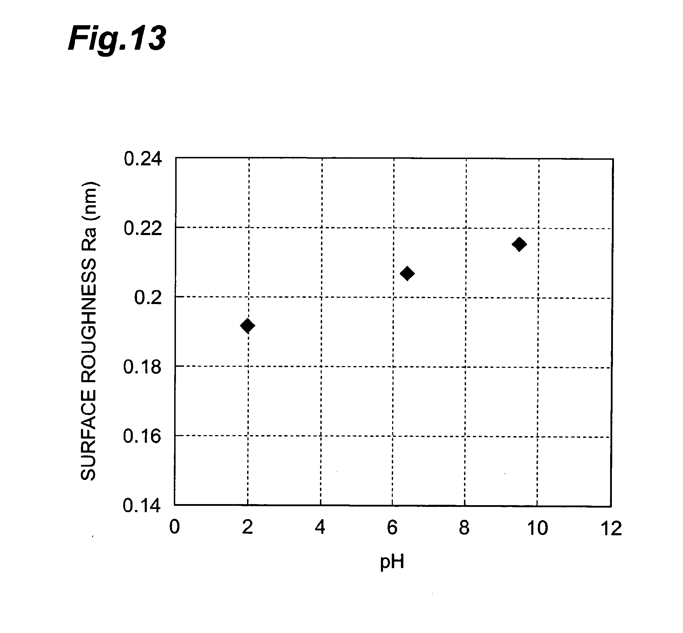

Each GaAs substrate is treated by- the cleaning method as described in the above embodiments. A number of 4-inch insulating GaAs substrates are prepared. These substrates are treated with solutions having various hydrogen ion concentrations (pH) according to the above cleaning method. Fig. 13 shows the relationship between the surface roughnesses of the substrates treated with varied solutions and the hydrogen ion concentrations of the solutions. The lower the hydrogen ion concentration is, i.e., the higher the acidity is, the better the flatness of the surface of the acid-cleaned substrate. When the surface roughness is not more than 0.21 nm, pH is not more than 6.4. For this reason, pH of the cleaning solution is preferably not more than 6.4 in the last acid cleaning in the cleaning steps.

### (Eleventh Embodiment)

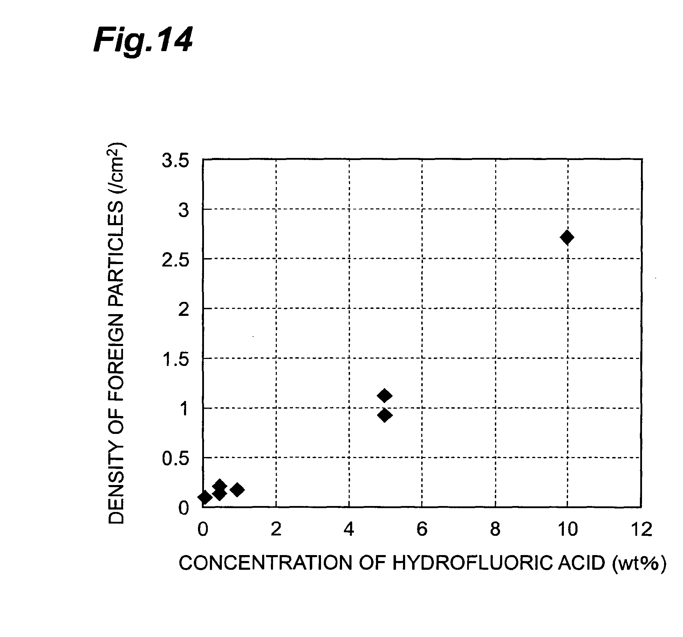

Each GaAs substrate is treated by the cleaning method as described in the above embodiments. A number of 3-inch insulating GaAs substrates are prepared. The whole of each GaAs substrate is immersed in a mixed solution of hydrofluoric acid solution and hydrogen peroxide solution for 10 seconds and then the whole of the GaAs substrate is immersed into deionized water. After the rinsing with deionized water, the GaAs substrate is dried with a centrifugal drier. The concentration of hydrofluoric acid is, for example, in the range of 0.1-10 wt%. The surface of the GaAs substrate thus treated is observed with a mirror surface scanner to count the number of precipitate particles of not less than 0.4 µm. Fig. 14 is a diagram showing the relationship between the density of precipitate particles (per cm²) and the concentration of hydrofluoric acid. When the concentration of hydrofluoric acid is not more than 5.0 wt%, the density of precipitate particles is small, e.g., not more than 1.2 particles/cm². The surface roughness and Ga/As of the GaAs substrate indicating the density of precipitate particles of not more than 1.2 particles/cm² are measured, and the surface roughness is not more than 0.21 nm and the Ga/As ratio is not more than 1.5. Namely, where the mixed solution of hydrofluoric acid solution and hydrogen peroxide solution is used in the last acid cleaning in the cleaning process, the concentration of hydrofluoric acid is preferably not more than 5.0 wt% in order to obtain the GaAs substrate demonstrating the surface roughness of 0.21 nm and the Ga/As ratio of not more than 1.5.

Japanese Patent Application Laid-Open No. 2000-340535 discloses the alkali cleaning carried out after the acid cleaning in order to remove the precipitate particles observed on the surface of the acid-cleaned substrate,. However, the cleaning with alkali tends to roughen the surface of GaAs, and increases the haze of the surface of the epitaxial layer after epitaxial growth. Furthermore, the alkali cleaning increases the cost of cleaning. The method according to the present invention permits stable production of the epitaxial film with less haze and the reduction of the number of defects even if the alkali cleaning is not carried out. Japanese Patent Application Laid-Open No. 11-219924 discloses the acid cleaning of the GaAs substrate in a dark place, but care is needed for handling of the acid solution in the dark place. The method according to the present invention requires no special environment, such as the dark place.

Since the alkaline solution is effective in the removal of microparticles, the following examples adopt the foregoing acid cleaning in a wafer production process.

### (Example 1)

A GaAs sliced wafers are mounted on a polishing ceramic plate with wax, and then the GaAs sliced wafers are polished with a chlorine-based abrasive by use of polishing cloth to form a GaAs mirror substrate. The chlorine-based abrasive contains, for example, an aqueous solution of a mixture of chlorinated isocyanuric acid, sodium phosphate, sodium carbonate, and sodium sulfate. The polishing cloth is, for example, urethane suede. The whole of this GaAs substrate is immersed in deionized water. After the GaAs substrate is peeled off the polishing plate, the GaAs substrate is immersed in an organic solution, such as alcohol, for cleaning by means of a batch type cleaning bath and the whole of the GaAs substrate is immersed in an alkaline solution for cleaning. Thereafter, the whole of the GaAs substrate is immersed into deionized water for rinsing with water. The GaAs substrate rinsed with water is dried by vapor drying using alcohol. Thereafter, the flatness of the GaAs substrate is measured, and then the acid cleaning and deionized water rinsing according to the embodiment of the present invention are executed by means of a batch type cleaning apparatus. After this, the GaAs substrate thus treated is dried by vapor drying with alcohol to prepare a GaAs wafer.

### (Example 2)

A GaAs sliced wafers are finished with a polisher. This polisher is provided with a suction plate in the upper axis. While the GaAs substrate is sucked by the suction plate, it is polished with a chlorine-based abrasive by use of urethane suede polishing cloth. The chlorine-based abrasive preferably contains, for example, an aqueous solution of a mixture of chlorinated isocyanuric acid, sodium phosphate, sodium carbonate, and sodium sulfate. After the polishing, the GaAs substrate is immersed in deionized water to be washed with water and thereafter the whole of the GaAs substrate is immersed in an alkaline solution by means of a batch type cleaning apparatus for alkali cleaning. Thereafter, the whole of the GaAs substrate is immersed in deionized water for washing with water. After this, the GaAs substrate is dried with a rotary drier. The surface of the GaAs substrate is inspected, and then each GaAs substrate is set to a rotary cleaning apparatus. Then, the whole of the GaAs substrate is immersed in an acid solution for acid cleaning. For rinsing, the whole of the GaAs substrate is immersed in deionized water and thereafter the GaAs substrate is dried by a centrifugal drier to produce a GaAs wafer.

Having described and illustrated the principle of the invention in a preferred embodiment thereof, it is appreciated by those having skill in the art that the invention can be modified in arrangement and detail without departing from such principles. We therefore claim all modifications and variations coming within the spirit and scope of the following claims.

## Claims

1. A method of cleaning a GaAs substrate, comprising:
an acid cleaning step of subjecting a GaAs substrate to cleaning using an acid solution for less than 30 seconds.

2. A method of cleaning a GaAs substrate, comprising:
an acid cleaning step of subjecting a GaAs substrate to a plurality of acid cleanings, an acid solution for one acid cleaning of the plurality of acid cleanings being different from that for another cleaning thereof, and a total period of time for the plurality of acid cleanings being less than 30 seconds.

3. A method of cleaning a GaAs substrate, comprising:
an alkali cleaning step of subjecting a GaAs substrate to cleaning using an alkaline solution; and
an acid cleaning step of subjecting the GaAs substrate to cleaning using an acid solution after the alkali cleaning step,
wherein ultrasonic wave is applied to the GaAs substrate during the cleaning in the alkali cleaning step, and
wherein a cleaning time in the acid cleaning step is less than 30 seconds.

4. A method of cleaning a GaAs substrate, comprising:
a first acid cleaning step of subjecting a GaAs substrate to cleaning using an acid solution;
an alkali cleaning step of subjecting the GaAs substrate to cleaning using an alkaline solution after the first acid cleaning step; and
a second acid cleaning step of subjecting the GaAs substrate to cleaning using an acid solution after the alkali cleaning step,
wherein a cleaning time in the second acid cleaning step is less than 30 seconds.

5. The method of cleaning a GaAs substrate according to claim 4, wherein ultrasonic wave is applied to the GaAs substrate during the cleaning in the alkali cleaning step.

6. The method of cleaning a GaAs substrate according to any one of claims 3 to 5, wherein the alkaline solution contains at least one of ammonia, ethylhydroxyl, 2-ethoxyethylamine, triethanolamine, diethanolamine, ethylamine, trimethylamine, diethylamine, dimethylamine, ethanolamine, trimethylammonium hydroxide, tetraethylammonium-hydroxide, and tetramethylammonium hydroxide.

7. The method of cleaning a GaAs substrate according to any one of claims 1 to 6, wherein the acid solution contains at least one of nitric acid, hydrofluoric acid, hydrochloric acid, phosphoric acid, sulfuric acid, acetic acid, carbonic acid, lactic acid, formic acid, citric acid, malic acid, and phthalic acid.

8. A method of producing a GaAs wafer, comprising the steps of:
polishing a surface of a GaAs slice prepared by slicing a GaAs single crystal ingot, to form a GaAs substrate; and
subjecting the polished GaAs substrate to the cleaning method as set forth in any one of claims 1 to 7.

9. A method of producing an epitaxial substrate, comprising the steps of:
subjecting a GaAs substrate to the cleaning method as set forth in any one of claims 1 to 7; and
growing an epitaxial film on the cleaned GaAs substrate.

10. A method of cleaning a GaAs substrate for production of a GaAs wafer, comprising the step of:
treating a surface of the GaAs substrate with an acid solution for less than 30 seconds.

11. A method of cleaning a GaAs substrate for production of a GaAs wafer, comprising the step of:
subjecting a surface of the GaAs substrate to a plurality of treatments using a plurality of acid solutions, one acid solution in one treatment of the plurality of treatments being different from that in another treatment thereof, and a total period of time for the treatment of the GaAs substrate with the acid solutions being less than 30 seconds.

12. A method of cleaning a GaAs substrate for production of a GaAs wafer, comprising the steps of:
treating the GaAs substrate with an alkaline solution; and
treating the GaAs substrate with an acid solution for less than 30 seconds, after treating the GaAs substrate with the alkaline solution,
wherein the step of treating the GaAs substrate with the alkaline solution comprises a step of immersing the GaAs substrate in the alkaline solution while applying ultrasonic wave.

13. A method of cleaning a GaAs substrate for production of a GaAs wafer, comprising the steps of:
treating the GaAs substrate with an acid solution;
treating the GaAs substrate with an alkaline solution after treating the GaAs substrate with the acid solution; and
treating the GaAs substrate with an acid solution for less than 30 seconds after treating the GaAs substrate with the alkaline solution.

14. The method according to claim 13, wherein the step of treating the GaAs substrate with the alkaline solution comprises a step of immersing the GaAs substrate in the alkaline solution while applying ultrasonic wave to the alkaline solution.

15. A method of cleaning a GaAs substrate for production of a GaAs wafer, comprising the step of:
treating a GaAs substrate with an acid solution, the acid solution having a hydrogen ion concentration (pH) of not more than 6.4.

16. A method of cleaning a GaAs substrate for production of a GaAs wafer, comprising the step of:
treating a GaAs substrate with an acid solution, the acid solution being a mixed solution of hydrofluoric acid and hydrogen peroxide solution, and a concentration of the hydrofluoric acid in the mixed solution being not more than 5.0 wt%.

17. The method according to claim 15 or claim 16, further comprising the step of:
prior to treating the GaAs substrate with the acid solution, treating the GaAs substrate with an alkaline solution.

18. The method according to any one of claims 12 to 14 and claim 17, wherein the alkaline solution contains at least one of ammonia, ethylhydroxyl, 2-ethoxyethylamine, triethanolamine, diethanolamine, ethylamine, trimethylamine, diethylamine, dimethylamine, ethanolamine, trimethylammonium hydroxide, tetraethylammonium hydroxide, and tetramethylammonium hydroxide.

19. The method according to any one of claims 10 to 18,
wherein the acid solution contains at least one of nitric acid, hydrofluoric acid, hydrochloric acid, phosphoric acid, sulfuric acid, acetic acid, carbonic acid, lactic acid, formic acid, citric acid, malic acid, and phthalic acid.

20. A method of fabricating a GaAs wafer, comprising the steps of:
polishing a surface of a GaAs sliced wafer prepared by slicing a GaAs single crystal ingot to form a GaAs substrate; and
treating the GaAs substrate by the method as set forth in any one of claims 10 to 19, to produce the GaAs wafer.

21. A method of fabricating an epitaxial substrate, comprising the steps of:
treating a GaAs substrate by the method as set forth in any one of claims 10 to 19 to produce a GaAs wafer; and
growing one or more epitaxial films on the GaAs wafer.

22. A GaAs wafer including a cleaned primary surface, wherein the primary surface has a characteristic that a ratio of an area of a Ga (3d) peak intensity to an area of an As (3d) peak intensity in XPS evaluation is not less than 0.59.

23. The GaAs wafer according to claim 22, wherein precipitate particles of not less than 0.4 µm on the primary surface are not more than 15 particles/12.57 inch².

24. A GaAs wafer including a cleaned primary surface, wherein the primary surface has a surface roughness of not more than 0.21 nm.

25. A GaAs wafer including a cleaned primary surface, wherein the primary surface has a characteristic that a ratio of an area of a Ga (3d) peak intensity to an area of an As (3d) peak intensity in an XPS spectrum is not more than 1.5.

26. The GaAs wafer according to claim 24 or claim 25, wherein precipitate particles on the primary surface are not more than 1.2 particles/cm².
